# EUROPEAN PATENT SPECIFICATION

(11) **EP 3 835 858 B1**
(45) Date of publication and mention of the grant of the patent: **07.10.2026**
(21) Application number: 19847864.6
(22) Date of filing: 01.08.2019
(51) Int. Cl.: H10D 86/40, H10D 86/60, G02F 1/1345, G02F 1/1362, H10W 44/00

(54) **ARRAY SUBSTRATE AND DISPLAY DEVICE**
ARRAYSUBSTRAT UND ANZEIGEVORRICHTUNG
SUBSTRAT DE RÉSEAU ET DISPOSITIF D'AFFICHAGE

(30) Priority: 07.08.2018 CN 201821266166 U
(43) Date of publication of application: 16.06.2021
(73) Proprietor: BOE TECHNOLOGY GROUP CO., LTD., Beijing 100015 (CN)
(72) Inventor: CHENG, Hongfei, Beijing 100176 (CN)
(74) Representative: AWA Sweden AB
(86) International application number: PCT/CN2019/098895
(87) International publication number: WO 2020/029865

(56) References cited:
- WO-A1-2015/062273
- CN-A- 101 697 053
- CN-A- 102 253 507
- CN-A- 103 399 434
- CN-A- 106 158 881
- CN-U- 203 241 671
- CN-U- 208 422 916
- US-A1- 2008 001 892
- US-A1- 2012 206 684
- US-A1- 2016 358 938
- US-A1- 2016 358 939

## Description

### CROSS-REFERENCE TO RELATED APPLICATION

The present disclosure claims priority from the Chinese Patent Application No.201821266166.8 filed on August 7, 2018.

### TECHNICAL FIELD

The present disclosure relates to the field of display technology, and particularly relates to an array substrate and a display device.

### BACKGROUND

Due to different impedances of different leads on an array substrate, when different leads are used for conducting the same data signals, gate line signals or clock signals, data signals, gate line signals or clock signals obtained through different leads may be different, resulting in poor uniformity of images displayed by a display including the array substrate.

US patent application US20120206684A1 discloses a liquid crystal display, which includes a first substrate including a display area and a fan-out area, a plurality of pixels disposed in the display area; a dam disposed in the fan-out area, and a plurality of display signal lines disposed on the first substrate, where the plurality of display signal lines is connected to the plurality of pixels in the display area, the plurality of display signal lines includes a plurality of wiring units in the fan-out area, the dam is disposed in a dummy area between the plurality of wiring units, and a shape of the dam is different from a shape of the plurality of wiring units.

US patent application US20160358939A1 discloses a display apparatus, which includes: a first substrate including a display area and a non-display area adjacent to the display area; a second substrate facing the first substrate; a display device disposed between the first substrate and the second substrate; and a fan-out line, disposed in the non-display area, to apply a display signal to the display device. The fan-out line includes: a first conductive layer; and a second conductive layer disposed on the first conductive layer, the second conductive layer being electrically connected to the first conductive layer. A width of the first conductive layer is different from a width of the second conductive layer.

US patent application US20160358938A1 discloses a display device having a display area and a non-display area, which display device includes a substrate, a pixel at the display area, a signal line on the substrate and electrically connected to the pixel, and a static electricity prevention capacitor at the non-display area and including a lower pattern having a first region and a second region that have different electrical conductivities from each other, an insulating layer on the lower pattern, and an upper pattern including a portion of the signal line and overlapping the first region of the lower pattern in a plan view.

### SUMMARY

According to the invention there is provided an array substrate as defined in claim 1. Further developments of the invention are the subject of the dependent claims.

In an embodiment of the present disclosure, there is provided an array substrate, including a display area and a fan-out area, wherein the array substrate includes: a base and at least one lead structure disposed on the base in the fan-out area. The lead structure includes a first conductive structure and a conductive semiconductor structure, and an orthographic projection of the conductive semiconductor structure on the base at least partially overlaps an orthographic projection of the first conductive structure on the base, and the first conductive structure is configured to transmit data signals, gate line signals, or clock signals. The lead structure further comprises a second conductive structure, and an orthographic projection of the second conductive structure on the base at least partially overlaps the orthographic projection of the first conductive structure on the base, the first conductive structure is located between the second conductive structure and the conductive semiconductor structure with respect to the base. The array substrate comprises a thin film transistor disposed on the base in the display area; wherein one of the first conductive structure and the second conductive structure is disposed in a same layer as a gate of the thin film transistor, and comprises a same material as the gate of the thin film transistor, and the other of the first conductive structure and the second conductive structure is disposed in a same layer as a source and a drain of the thin film transistor, and comprises a same material as the source and the drain of the thin film transistor, the conductive semiconductor structure is disposed in a same layer as an active layer of the thin film transistor. A first insulating layer is disposed between the first conductive structure and the conductive semiconductor structure, a second insulating layer is disposed between the first conductive structure and the second conductive structure, and the first insulating layer and the second insulating layer are sequentially disposed on the base; and the conductive semiconductor structure is disposed on a side of the base proximal to the first insulating layer, the first conductive structure is disposed on a side of the first insulating layer distal to the base, and the second conductive structure is disposed on a side of the second insulating layer distal to the base. The array substrate comprises a plurality of lead structures arranged in a direction parallel to an extension direction of the array substrate, each of the lead structures comprises a first conductive structure, the plurality of lead structures share a single common second conductive structure, and the plurality of lead structures share a single common conductive semiconductor structure; and via holes are disposed on two sides of the first conductive structure and only one via hole is disposed between any two adjacent first conductive structures, and the via holes penetrate the second insulating layer and the first insulating layer such that the single common conductive semiconductor structure is electrically connected to the single common second conductive structure through the via holes.

In some embodiments, the first conductive structure is disposed in a same layer as a gate of the thin film transistor, and includes a same material as the gate of the thin film transistor.

In some embodiments, a gate insulating layer is disposed between the gate of the thin film transistor and the active layer of the thin film transistor; and the conductive semiconductor structure is disposed on a side of the base close to the gate insulating layer, and the first conductive structure is disposed on a side of the gate insulating layer away from the base.

In some embodiments, an interlayer insulating layer is disposed between a source and a drain of the thin film transistor and the active layer of the thin film transistor, and the source and the drain of the thin film transistor are disposed on a side of the interlayer insulating layer away from the base.

In some embodiments, the source and the drain of the thin film transistor are disposed on a side of the gate of the thin film transistor away from the base, and the interlayer insulating layer is disposed on a side of the gate insulating layer away from the base.

In some embodiments, the gate of the thin film transistor is disposed on a side of the source and the drain of the thin film transistor away from the base, and the gate insulating layer is disposed on a side of the interlayer insulating layer away from the base.

In some embodiments, the first conductive structure is disposed in a same layer as a source and a drain of the thin film transistor, and includes a same material as the source and the drain of the thin film transistor.

In some embodiments, the conductive semiconductor structure is disposed in a same layer as an active layer of the thin film transistor; an interlayer insulating layer is disposed between the source and the drain of the thin film transistor and the active layer of the thin film transistor; and the conductive semiconductor structure is disposed on a side of the base close to the interlayer insulating layer, and the first conductive structure is disposed on a side of the interlayer insulating layer away from the base.

In some embodiments, a gate insulating layer is disposed between a gate of the thin film transistor and the active layer of the thin film transistor, and the gate of the thin film transistor is disposed on a side of the gate insulating layer away from the base.

In some embodiments, the source and the drain of the thin film transistor are disposed on a side of the gate of the thin film transistor away from the base, and the interlayer insulating layer is disposed on a side of the gate insulating layer away from the base.

In some embodiments, the gate of the thin film transistor is disposed on a side of the source and the drain of the thin film transistor away from the base, and the gate insulating layer is disposed on a side of the interlayer insulating layer away from the base.

In some embodiments, the second conductive structure includes metal.

In some embodiments, the conductive semiconductor structure includes a conductive low-temperature polysilicon layer.

In some embodiments, the first conductive structure includes metal.

In an embodiment of the present disclosure, there is further provided a display device including the array substrate as described above.

### BRIEF DESCRIPTION OF DRAWINGS

Fig. 1 is a schematic plan view showing a structure of an array substrate according to an embodiment of the present disclosure;
Fig. 2 shows an exemplary cross-sectional view of a lead structure in a fan-out area of the array substrate taken along line B-B' of Fig. 1 and a schematic cross-sectional view of a corresponding thin film transistor in a display area in an embodiment of the present disclosure;
Fig. 3 shows an exemplary cross-sectional view of a lead structure in a fan-out area of the array substrate taken along line B-B' of Fig. 1 and a schematic cross-sectional view of a corresponding thin film transistor in a display area in an embodiment of the present disclosure;
Fig. 4 shows an exemplary cross-sectional view of a lead structure in a fan-out area of the array substrate taken along line B-B' of Fig. 1 and a schematic cross-sectional view of a corresponding thin film transistor in a display area in an embodiment of the present disclosure;
Fig. 5 shows an exemplary cross-sectional view of a lead structure in a fan-out area of the array substrate taken along line B-B' of Fig. 1 and a schematic cross-sectional view of a corresponding thin film transistor in a display area in an embodiment of the present disclosure;
Fig. 6 shows an exemplary cross-sectional view of the array substrate taken along line B-B' of Fig. 1 in an embodiment of the present disclosure;
Fig. 7 shows an exemplary cross-sectional view of the array substrate taken along line B-B' of Fig. 1 in an embodiment of the present disclosure; and
Fig. 8 shows an exemplary cross-sectional view of the array substrate taken along line B-B' of Fig. 1 in an embodiment of the present disclosure.

### DETAILED DESCRIPTION

In order to enable those skilled in the art to better understand the technical solutions of the present disclosure, the present disclosure will be described in detail below with reference to accompanying drawings and specific embodiments.

Unless otherwise defined, technical or scientific terms used in the present disclosure are intended to have general meanings as understood by those of ordinary skill in the art. The words "first", "second" and similar terms used in the present disclosure do not denote any order, quantity, or importance, and are used merely for distinguishing different components. The word "comprising", "comprises" or the like means that an element, item preceding the word includes elements, items and equivalents thereof that appear after the word, and does not exclude other elements or items. The words "upper", "lower", or the like are merely used to indicate a relative positional relationship, and when an absolute positional relationship between the described objects is changed, the relative positional relationship may also be changed accordingly.

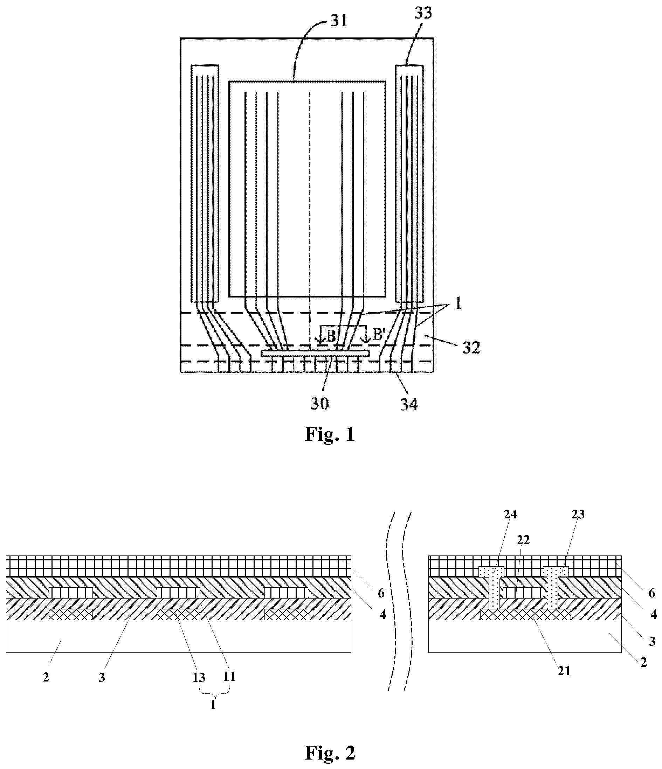

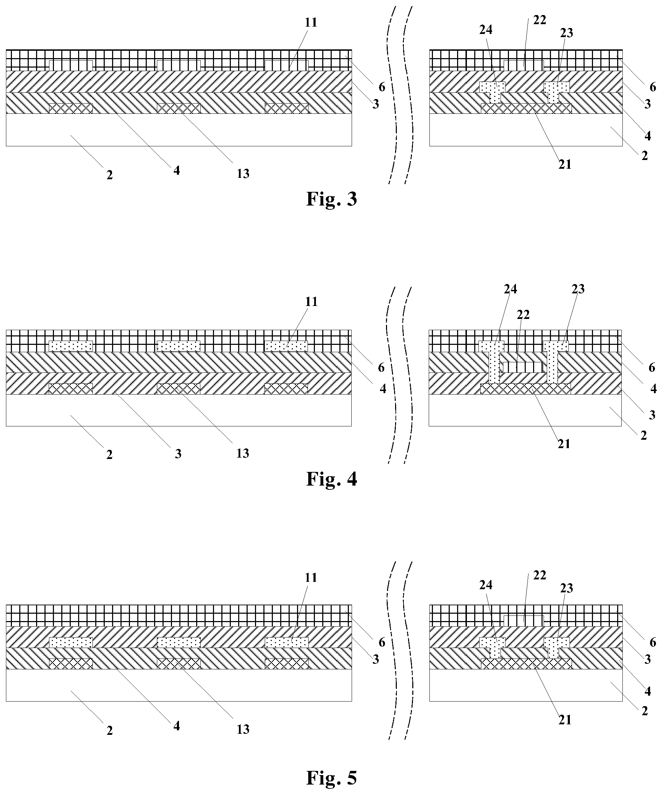

Fig. 1 is a schematic plan view showing a structure of an array substrate according to an embodiment of the present disclosure. Fig. 2 shows an exemplary cross-sectional view of a lead structure in a fan-out area of the array substrate taken along line B-B' of Fig. 1 and a schematic cross-sectional view of a corresponding thin film transistor in a display area. Fig. 3 shows an exemplary cross-sectional view of a lead structure in a fan-out area of the array substrate taken along line B-B' of Fig. 1 and a schematic cross-sectional view of a corresponding thin film transistor in a display area. Fig. 4 shows an exemplary cross-sectional view of a lead structure in a fan-out area of the array substrate taken along line B-B' of Fig. 1 and a schematic cross-sectional view of a corresponding thin film transistor in a display area. Fig. 5 shows an exemplary cross-sectional view of a lead structure in a fan-out area of the array substrate taken along line B-B' of Fig. 1 and a schematic cross-sectional view of a corresponding thin film transistor in a display area.

As shown in Figs. 1 to 5, in an embodiment of the present disclosure, there is provided an array substrate including a base 2 and at least one lead structure 1 disposed on the base 2. The lead structure 1 includes a first conductive structure 11 and a conductive semiconductor structure 13, and an orthographic projection of the conductive semiconductor structure 13 on the base 2 at least partially overlaps an orthographic projection of the first conductive structure 11 on the base 2. In some embodiments, as shown in Figs. 2 to 5, the array substrate includes a plurality of lead structures 1.

As shown in Fig. 1, the array substrate includes a display area 31 and a fan-out area 32 outside the display area. In some embodiments, the at least one lead structure 1 is located in the fan-out area 32 of the array substrate. A circuitry in the fan-out area 32 is configured to connect a circuitry in the display area 31 to pads 34 via a driver integrated circuit (IC) 30, and connect a circuitry in a gate driver on array (GOA) 33 to the pads 34.

Since the lead structure 1 includes the conductive semiconductor structure 13, and the orthographic projection of the conductive semiconductor structure 13 on the base 2 at least partially overlaps the orthographic projection of the first conductive structure 11 on the base 2, the conductive semiconductor structure 13 and the first conductive structure 11 may interact with each other to form a parallel plate capacitor. In other words, the conductive semiconductor structure 13 may form a capacitor with the first conductive structure 11.

Capacitance of the parallel plate capacitor may be determined by the following Equation (1): $C = εS / 4 πkd$ (1) where C is the capacitance of the parallel plate capacitor, S is a facing area between the two plates of the parallel plate capacitor, d is a distance between the two plates of the parallel plate capacitor, ε is a relative dielectric constant between the two plates of the parallel plate capacitor, k is the electrostatic constant, and π is the circumference ratio.

According to the above Equation (1), regarding the capacitor formed by the conductive semiconductor structure 13 and the first conductive structure 11, the facing area between the conductive semiconductor structure 13 and the first conductive structure 11 can be adjusted by changing position and/or length of the conductive semiconductor structure 13, so as to adjust the capacitance of the capacitor.

Capacitive reactance of the parallel plate capacitor may be determined by the following Equation (2): $Xc = 1 / 2 πfC$ (2) where Xc is the capacitive reactance of the parallel plate capacitor, π is the circumference ratio, f is a frequency of alternating current applied to the parallel plate capacitor, and C is the capacitance of the parallel plate capacitor.

According to the above Equation (2), regarding the capacitor formed by the conductive semiconductor structure 13 and the first conductive structure 11, the capacitive reactance of the capacitor can be adjusted by changing the capacitance of the capacitor, so as to adjust impedance of the first conductive structure 11 as one plate of the capacitor. Thus, in conjunction with the above Equations (1) and (2), the impedance of the first conductive structure 11 can be adjusted by adjusting the position and/or length of the conductive semiconductor structure 13 during fabrication of the array substrate. Therefore, in a case where the array substrate includes a plurality of first conductive structures 11, the impedance of each first conductive structure 11 can be adjusted by adjusting the position and/or length of the conductive semiconductor structure 13 forming a capacitor with that first conductive structure 11 during fabrication of the array substrate so that the respective first conductive structures 11 have a same or substantially a same impedance. In this case, when the plurality of first conductive structures 11 are expected to transmit a same data signal, gate line signal, or clock signal, it is ensured that each of the first conductive structures 11 actually outputs the same or substantially the same data signal, gate line signal, or clock signal, and thus the display effect of a display including the array substrate according to the embodiments of the present disclosure is improved.

In order to simplify fabrication process of the array substrate, in some embodiments, the array substrate includes a thin film transistor disposed on the base 2. In some embodiments, the first conductive structure 11 is disposed in a same layer as a gate 22 of the thin film transistor, and includes a same material as the gate 22 of the thin film transistor. In some embodiments, the first conductive structure 11 is disposed in a same layer as a source 23 and a drain 24 of the thin film transistor, and includes a same material as the source 23 and the drain 24 of the thin film transistor. In some embodiments, the conductive semiconductor structure 13 is disposed in a same layer as an active layer 21 of the thin film transistor.

In some embodiments, as shown in Fig. 2, when the first conductive structure 11 is disposed in the same layer as the gate 22 of the thin film transistor, and the conductive semiconductor structure 13 is disposed in the same layer as the active layer 21 of the thin film transistor, a gate insulating layer 3 is disposed between the gate 22 of the thin film transistor and the active layer 21 of the thin film transistor, and the conductive semiconductor structure 13 is disposed on a side of the base 2 close to the gate insulating layer 3, while the first conductive structure 11 is disposed on a side of the gate insulating layer 3 away from the base 2. In this case, in some embodiments, as shown in Fig. 2, an interlayer insulating layer 4 is disposed between the source 23 and the drain 24 of the thin film transistor and the active layer 21 of the thin film transistor, and the source 23 and the drain 24 of the thin film transistor are disposed on a side of the interlayer insulating layer 4 away from the base 2. In this case, in some embodiments, as shown in Fig. 2, the source 23 and the drain 24 of the thin film transistor are disposed on a side of the gate 22 of the thin film transistor away from the base 2, and the interlayer insulating layer 4 is disposed on a side of the gate insulating layer 3 away from the base 2. However, the present disclosure is not limited thereto. For example, in some embodiments, as shown in Fig. 3, the gate 22 of the thin film transistor is disposed on a side of the source 23 and the drain 24 of the thin film transistor away from the base 2, and the gate insulating layer 3 is disposed on a side of the interlayer insulating layer 4 away from the base 2.

Therefore, according to the above embodiments of the present disclosure, the conductive semiconductor structure 13 of the fan-out area is disposed below the first conductive structure 11, and the impedance of the first conductive structure 11 can be adjusted by changing the position of the conductive semiconductor structure 13 below the first conductive structure 11 and/or the length of the conductive semiconductor structure 13, thereby ensuring that different first conductive structures 11 can output the same data signal, gate line signal, or clock signal, and improving the display effect of a display including the array substrate according to the embodiments of the present disclosure.

In some embodiments, as shown in Fig. 4, when the first conductive structure 11 is disposed in the same layer as the source 23 and the drain 24 of the thin film transistor, and the conductive semiconductor structure 13 is disposed in the same layer as the active layer 21 of the thin film transistor, an interlayer insulating layer 4 is disposed between the active layer 21 of the thin film transistor and the source 23 and the drain 24 of the thin film transistor, and the conductive semiconductor structure 13 is disposed on a side of the base 2 close to the interlayer insulating layer 4, while the first conductive structure 11 is disposed on a side of the interlayer insulating layer 4 away from the base 2. In this case, in some embodiments, as shown in Fig. 4, a gate insulating layer 3 is disposed between the gate 22 of the thin film transistor and the active layer 21 of the thin film transistor, and the gate 22 of the thin film transistor is disposed on a side of the gate insulating layer 3 away from the base 2. In this case, in some embodiments, as shown in Fig. 4, the source 23 and the drain 24 of the thin film transistor are disposed on a side of the gate 22 of the thin film transistor away from the base 2, and the interlayer insulating layer 4 is disposed on a side of the gate insulating layer 3 away from the base 2. However, the present disclosure is not limited thereto. For example, in some embodiments, as shown in Fig. 5, the gate 22 of the thin film transistor is disposed on a side of the source 23 and the drain 24 of the thin film transistor away from the base 2, and the gate insulating layer 3 is disposed on a side of the interlayer insulating layer 4 away from the base 2.

Therefore, according to the above embodiments of the present disclosure, the conductive semiconductor structure 13 is disposed below the first conductive structure 11, and the impedance of the first conductive structure 11 can be adjusted by changing the position of the conductive semiconductor structure 13 below the first conductive structure 11 and/or the length of the conductive semiconductor structure 13, thereby ensuring that different first conductive structures 11 can output the same data signal, gate line signal, or clock signal, and improving the display effect of a display including the array substrate according to the embodiments of the present disclosure.

In some embodiments, the array substrate further includes a passivation layer 6 that is used to protect one of the gate insulating layer 3 and the interlayer insulating layer 4 farther away from the base 2, and the passivation layer 6 is disposed on a side away from the base 2 of the one of the gate insulating layer 3 and the interlayer insulating layer 4 farther away from the base 2.

It will be appreciated that in some embodiments, positions of the source 23 and the drain 24 of the thin film transistor may be interchanged.

In some embodiments, the first conductive structure 11 is formed by a material including a metal. Metal materials have good electrical conductivity, which can help to adjust the impedance of the first conductive structure 11 using the conductive semiconductor structure 13. However, the present disclosure is not limited thereto. The first conductive structure 11 may include any material having a good conductivity that can help to adjust the impedance of the first conductive structure 11 using the conductive semiconductor structure 13.

In some embodiments, the conductive semiconductor structure 13 may include a conductive low-temperature polysilicon layer. However, the present disclosure is not limited thereto. That is, the conductive semiconductor structure 13 of the present disclosure is not limited to the conductive low-temperature polysilicon layer. In some embodiments, conductive low-temperature polysilicon may be obtained by doping phosphorus, boron, or the like into low-temperature polysilicon. However, the present disclosure is not limited thereto. That is, the method for preparing the conductive low-temperature polysilicon is not limited herein.

In summary, in the array substrate according to the embodiments of the present disclosure, the conductive semiconductor structure 13 may be disposed on the base 2 and may be at least partially overlapped with the first conductive structure 11, such that the conductive semiconductor structure 13 and the first conductive structure 11 form a capacitor. In this case, the impedance of the first conductive structure 11 can be adjusted by changing the position and/or length of the conductive semiconductor structure 13, thereby ensuring that that different first conductive structures 11 transmitting the same data signal, gate line signal, or clock signal have the same impedance, and improving the display effect of a display including the array substrate according to the embodiments of the present disclosure.

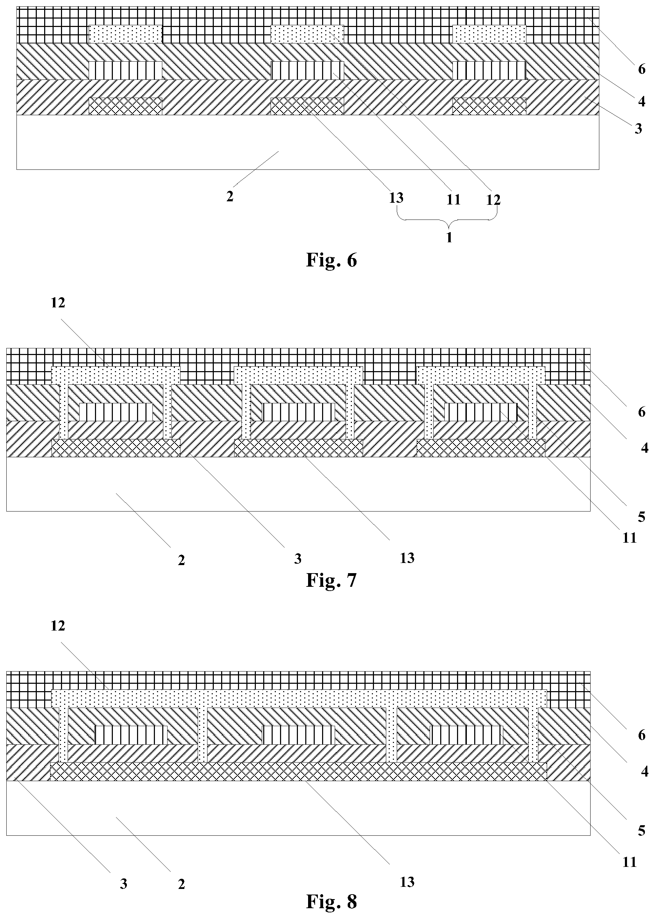

Fig. 6 shows an exemplary cross-sectional view of a lead structure in a fan-out area of the array substrate taken along line B-B' of Fig. 1. Fig. 7 shows an exemplary cross-sectional view of a lead structure in a fan-out area of the array substrate taken along line B-B' of Fig. 1. Fig. 8 shows an exemplary cross-sectional view of a lead structure in a fan-out area of the array substrate taken along line B-B' of Fig. 1.

As shown in Figs. 6 to 8, in an embodiment of the present disclosure, there is provided an array substrate including a base 2, and at least one lead structure 1 disposed on the base 2. The lead structure 1 includes a first conductive structure 11, a conductive semiconductor structure 13, and a second conductive structure 12. An orthographic projection of the conductive semiconductor structure 13 on the base 2 at least partially overlaps an orthographic projection of the first conductive structure 11 on the base 2, and an orthographic projection of the second conductive structure 12 on the base 2 at least partially overlaps the orthographic projection of the first conductive structure 11 on the base 2. In some embodiments, as shown in Figs. 6 to 8, the array substrate includes a plurality of lead structures 1.

Since the array substrate includes the conductive semiconductor structure 13 and the second conductive structure 12, and the orthographic projections of the conductive semiconductor structure 13 and the second conductive structure 12 on the base 2 each at least partially overlaps the orthographic projection of the first conductive structure 11 on the base 2, the conductive semiconductor structure 13 may form a parallel plate capacitor with the first conductive structure 11, and the second conductive structure 12 may also form a parallel plate capacitor with the first conductive structure 11. In other words, the conductive semiconductor structure 13 and the second conductive structure 12 may each form a capacitor with the first conductive structure 11. Therefore, according to the above Equations (1) and (2), the impedance of the first conductive structure 11 can be adjusted by changing the positions and/or lengths of the conductive semiconductor structure 13 and the second conductive structure 12, thereby ensuring that different first conductive structures 11 transmitting the same data signal, gate line signal, or clock signal have the same impedance, and improving the display effect of a display including the array substrate according to the embodiments of the present disclosure. Furthermore, as described in detail below, since the conductive semiconductor structure 13 and the second conductive structure 12 each form a capacitor with the first conductive structure 11, the capacitor formed by the conductive semiconductor structure 13 and the first conductive structure 11 and the capacitor formed by the second conductive structure 12 and the first conductive structure 11 may be in series or in parallel. Therefore, the impedance of the second conductive structure 12 can be adjusted by changing the positions and/or lengths of the conductive semiconductor structure 13 and the first conductive structure 11, thereby ensuring that that different second conductive structures 12 transmitting the same data signal, gate line signal, or clock signal have a same impedance, and improving the display effect of a display including the array substrate according to the embodiments of the present disclosure.

In an embodiment of the present disclosure, as shown in Figs. 6 to 8, the first conductive structure 11 is located between the second conductive structure 12 and the conductive semiconductor structure 13 with respect to the base 2.

In order to simplify the fabrication process of the array substrate, in some embodiments, the array substrate includes a thin film transistor disposed on the base 2. In some embodiments, one of the first conductive structure 11 and the second conductive structure 12 is disposed in the same layer as the gate of the thin film transistor, and includes the same material as the gate of the thin film transistor, and the other of the first conductive structure 11 and the second conductive structure 12 is disposed in the same layer as the source and the drain of the thin film transistor, and includes the same material as the source and the drain of the thin film transistor. In some embodiments, the conductive semiconductor structure 13 is disposed in the same layer as the active layer of the thin film transistor. In this case, in some embodiments, a first insulating layer is disposed between the first conductive structure 11 and the conductive semiconductor structure 13, a second insulating layer is disposed between the first conductive structure 11 and the second conductive structure 12, the first insulating layer and the second insulating layer are sequentially disposed on the base 2, the conductive semiconductor structure 13 is disposed on a side of the base 2 close to the first insulating layer, the first conductive structure 11 is disposed on a side of the first insulating layer away from the base 2, and the second conductive structure 12 is disposed on a side of the second insulating layer away from the base 2.

Specifically, positions of the first conductive structure 11, the second conductive structure 12, and the conductive semiconductor structure 13 are described in detail below by taking the case where the first conductive structure 11 is disposed in the same layer as the gate of the thin film transistor, the second conductive structure 12 is disposed in the same layer as the source and the drain of the thin film transistor, and the conductive semiconductor structure 13 is disposed in the same layer as the active layer of the thin film transistor. However, the present disclosure is not limited thereto. For example, in some embodiments, similar to the embodiment shown in Fig. 5, the first conductive structure 11 is disposed in the same layer as the source and the drain of the thin film transistor, the second conductive structure 12 is disposed in the same layer as the gate of the thin film transistor, and the conductive semiconductor structure 13 is disposed in the same layer as the active layer of the thin film transistor.

As shown in Fig. 6, similar to the embodiment shown in Fig. 3, in the case where the first conductive structure 11 is disposed in the same layer as the gate of the thin film transistor, the second conductive structure 12 is disposed in the same layer as the source and the drain of the thin film transistor, and the conductive semiconductor structure 13 is disposed in the same layer as the active layer of the thin film transistor, a gate insulating layer 3 (corresponding to the first insulating layer) is disposed between the gate and the active layer of the thin film transistor, an interlayer insulating layer 4 (corresponding to the second insulating layer) is disposed between the gate of the thin film transistor and the source and the drain of the thin film transistor, the gate insulating layer 3 and the interlayer insulating layer 4 are sequentially disposed on the base 2, and the conductive semiconductor structure 13 is disposed on a side of the base 2 close to the gate insulating layer 3, the first conductive structure 11 is disposed on a side of the gate insulating layer 3 away from the base 2, and the second conductive structure 12 is disposed on a side of the interlayer insulating layer 4 away from the base 2.

Therefore, in the array substrate according to the embodiments of the present disclosure, the second conductive structure 12 is disposed above the first conductive structure 11, and the conductive semiconductor structure 13 is disposed below the first conductive structure 11. Therefore, when it is required to adjust the impedance of the first conductive structure 11, the impedance of the first conductive structure 11 can be adjusted by adjusting the position and/or length of the second conductive structure 12 located above the first conductive structure 11 and by adjusting the position and/or length of the conductive semiconductor structure 13 located below the first conductive structure 11 during fabrication of the array substrate, thereby ensuring that different first conductive structures 11 can output the same data signal, gate line signal, or clock signal, and improving the display effect of a display including the array substrate according to the embodiments of the present disclosure. Furthermore, in the embodiment shown in Fig. 6, since the capacitor formed by the conductive semiconductor structure 13 and the first conductive structure 11 and the capacitor formed by the second conductive structure 12 and the first conductive structure 11 are in series, capacitive reactance of the two capacitors can be adjusted by adjusting the positions and/or lengths of the conductive semiconductor structure 13 and the first conductive structure 11 respectively, so as to adjust the impedance of the second conductive structure 12, thereby ensuring that different second conductive structures 12 transmitting the same data signal, gate line signal, or clock signal have the same impedance, and improving the display effect of a display including the array substrate according to the embodiments of the present disclosure.

In the embodiments of the present disclosure, the first conductive structure 11 and the second conductive structure 12 are configured to transmit data signals, gate line signals, or clock signals. However, the present disclosure is not limited thereto, and the first conductive structure 11 or the second conductive structure 12 may also be configured to transmit other signals.

In some embodiments, the array substrate includes a plurality of lead structures 1 arranged in a direction parallel to an extension direction of the array substrate. Each of the lead structures 1 includes a first conductive structure 11 on both sides of which via holes 5 are disposed. The via holes 5 penetrate the first insulating layer and the second insulating layer so that the conductive semiconductor structure 13 is connected to the second conductive structure 12 through the via holes 5.

In some embodiments, as shown in Fig. 7, the array substrate includes a plurality of lead structures 1 arranged in a direction parallel to an extension direction of the array substrate. Each of the lead structures 1 includes a first conductive structure 11, a second conductive structure 12, and a conductive semiconductor structure 13. In this case, in each of the lead structures 1, via holes 5 are disposed on both sides of the first conductive structure 11 of the lead structures 1, that is, each first conductive structure 11 corresponds to two via holes 5 which penetrate the gate insulating layer 3 and the interlayer insulating layer 4 so that the second conductive structure 12 is electrically connected to the conductive semiconductor structure 13 through these two via holes 5 to form a closed ring surrounding the first conductive structure 11 by the second conductive structure 12 and the conductive semiconductor structure 13. In this case, according to the principle of electrostatic shielding, the closed ring can isolate the first conductive structure 11 from the outside so that the first conductive structure 11 is prevented from damages of external static electricity, and lifetime of the array substrate according to the embodiments of the present disclosure is prolonged.

In some embodiments, as shown in Fig. 8, the array substrate includes a plurality of lead structures 1 arranged in a direction parallel to an extension direction of the array substrate. Each of the lead structures includes a first conductive structure 11, the plurality of lead structures 1 share a single common second conductive structure 12, and the plurality of lead structures 1 share a single common conductive semiconductor structure 13. In this case, via holes 5 are disposed on both sides of each first conductive structure 11, and only one via hole 5 is disposed between any two adjacent first conductive structures 11. Such an arrangement of the plurality of lead structures 1 can increase an area of each closed ring, so as to further ensure that the first conductive structure 11 is prevented from damages of external static electricity, and the lifetime of the array substrate according to the embodiments of the present disclosure is prolonged.

Further, in the embodiments shown in Figs. 7 and 8, since the capacitor formed by the conductive semiconductor structure 13 and the first conductive structure 11 and the capacitor formed by the second conductive structure 12 and the first conductive structure 11 are in parallel, the capacitive reactance of the two capacitors can be adjusted by adjusting the positions and/or lengths of the conductive semiconductor structure 13 and the first conductive structure 11 respectively, so as to adjust the impedance of the second conductive structure 12, thereby ensuring that different second conductive structures 12 transmitting the same data signal, gate line signal, or clock signal have the same impedance, and improving the display effect of a display including the array substrate according to the embodiments of the present disclosure.

In some embodiments, the first conductive structure 11 and the second conductive structure 12 are formed by a material including a metal. Metal materials have good electrical conductivity, which can help to adjust the impedance of the first conductive structure 11 using the conductive semiconductor structure 13 and the second conductive structure 12, and to adjust the impedance of the second conductive structure 12 using the conductive semiconductor structure 13 and the first conductive structure 11. However, the present disclosure is not limited thereto. The material forming the first conductive structure 11 may include any material having a good conductivity that can help to adjust the impedance of the first conductive structure 11 using the conductive semiconductor structure 13 and the second conductive structure 12, and the material forming the second conductive structure 12 may include any material having a good conductivity that can help to adjust the impedance of the second conductive structure 12 using the conductive semiconductor structure 13 and the first conductive structure 11.

In some embodiments, the conductive semiconductor structure 13 may include a conductive low-temperature polysilicon layer. However, the present disclosure is not limited thereto. That is, the conductive semiconductor structure 13 of the present disclosure is not limited to a conductive low-temperature polysilicon layer. In some embodiments, conductive low-temperature polysilicon may be obtained by doping phosphorus, boron, or the like into low-temperature polysilicon. However, the present disclosure is not limited thereto. That is, the method for preparing the conductive low-temperature polysilicon is not limited herein.

In summary, in the array substrate provided in the embodiments of the present disclosure, the conductive semiconductor structure 13, the first conductive structure 11, and the second conductive structure 12 may be disposed sequentially on the base 2, and the conductive semiconductor structure 13 and the second conductive structure 12 each may be at least partially overlapped with the first conductive structure 11, such that the conductive semiconductor structure 13 and the second conductive structure 12 each form a capacitor with the first conductive structure 11. In this case, the impedance of the first conductive structure 11 can be adjusted by changing the positions and/or lengths of the conductive semiconductor structure 13 and the second conductive structure 12, thereby ensuring that different first conductive structures 11 transmitting the same data signal, gate line signal, or clock signal have the same impedance, and improving the display effect of a display including the array substrate according to the embodiments of the present disclosure. In addition, the impedance of the second conductive structure 12 can be adjusted by changing the positions and/or lengths of the conductive semiconductor structure 13 and the first conductive structure 11, thereby ensuring that different second conductive structures 12 transmitting the same data signal, gate line signal, or clock signal have the same impedance, and improving the display effect of a display including the array substrate according to the embodiments of the present disclosure.

In an embodiment of the present disclosure, there is further provided a display device including the array substrate according to any of the embodiments disclosed herein. Images displayed by the display device according to the embodiment of the present disclosure have a good display effect, since the array substrate according to the embodiments of the present disclosure is included in the display device.

The display device may include: a liquid crystal panel, an electronic paper, a mobile phone, a tablet, a television, a monitor, a notebook computer, a digital album, a navigator, or any other product or component having a display function.

It will be appreciated that the above embodiments are merely exemplary embodiments for the purpose of illustrating the principle of the disclosure, and the disclosure is not limited thereto. Within the scope of the appended claims, various modifications and improvements can be made by an ordinary skilled in the art.

## Claims

1. An array substrate, comprising a display area (31) and a fan-out area (32), wherein the array substrate comprises a base (2) and at least one lead structure (1) disposed on the base (2) in the fan-out area (32), wherein the lead structure (1) comprises a first conductive structure (11) and a conductive semiconductor structure (13), and an orthographic projection of the conductive semiconductor structure (13) on the base (2) at least partially overlaps an orthographic projection of the first conductive structure (11) on the base (2), and the first conductive structure (11) is configured to transmit data signals, gate line signals, or clock signals,
**characterized in that** the lead structure (1) further comprises a second conductive structure (12), and an orthographic projection of the second conductive structure (12) on the base (2) at least partially overlaps the orthographic projection of the first conductive structure (11) on the base (2),
wherein the array substrate comprises a thin film transistor disposed on the base (2);
wherein one of the first conductive structure (11) and the second conductive structure (12) is disposed in a same layer as a gate (22) of the thin film transistor, and comprises a same material as the gate (22) of the thin film transistor, and the other of the first conductive structure (11) and the second conductive structure (12) is disposed in a same layer as a source (23) and a drain (24) of the thin film transistor, and comprises a same material as the source (23) and the drain (24) of the thin film transistor,
wherein a first insulating layer is disposed between the first conductive structure (11) and the conductive semiconductor structure (13), a second insulating layer is disposed between the first conductive structure (11) and the second conductive structure (12), and the first insulating layer and the second insulating layer are sequentially disposed on the base (2); and
the conductive semiconductor structure (13) is disposed on a side of the base (2) proximal to the first insulating layer, the first conductive structure (11) is disposed on a side of the first insulating layer distal to the base (2), and the second conductive structure (12) is disposed on a side of the second insulating layer distal to the base (2),
wherein the array substrate comprises a plurality of lead structures (1) arranged in a direction parallel to an extension direction of the array substrate, each of the lead structures (1) comprises a first conductive structure (11), the plurality of lead structures (1) share a single common second conductive structure (12), and the plurality of lead structures (1) share a single common conductive semiconductor structure (13); and
via holes (5) are disposed on both sides of the first conductive structure (11) and only one via hole (5) is disposed between any two adjacent first conductive structures (11), and the via holes (5) penetrate the second insulating layer and the first insulating layer such that the conductive semiconductor structure (13) is electrically connected to the second conductive structure (12) through the via holes (5).

2. The array substrate according to claim 1, wherein the first conductive structure (11) is disposed in a same layer as a gate (22) of the thin film transistor, and comprises a same material as the gate (22) of the thin film transistor.

3. The array substrate according to claim 2, wherein
a gate insulating layer (3) is disposed between the gate (22) of the thin film transistor and the active layer (21) of the thin film transistor; and
the conductive semiconductor structure (13) is disposed on a side of the base (2) proximal to the gate insulating layer (3), and the first conductive structure (11) is disposed on a side of the gate insulating layer (3) distal to the base (2).

4. The array substrate according to claim 3, wherein
an interlayer insulating layer (4) is disposed between a source (23) and a drain (24) of the thin film transistor and the active layer (21) of the thin film transistor, and the source (23) and the drain (24) of the thin film transistor are disposed on a side of the interlayer insulating layer (4) distal to the base (2).

5. The array substrate according to claim 4, wherein
the source (23) and the drain (24) of the thin film transistor are disposed on a side of the gate (22) of the thin film transistor distal to the base (2), and the interlayer insulating layer (4) is disposed on a side of the gate insulating layer (3) distal to the base (2), or
the gate (22) of the thin film transistor is disposed on a side of the source (23) and the drain (24) of the thin film transistor distal to the base (2), and the gate insulating layer (3) is disposed on a side of the interlayer insulating layer (4) distal to the base (2).

6. The array substrate according to claim 1, wherein the first conductive structure (11) is disposed in a same layer as a source (23) and a drain (24) of the thin film transistor, and comprises a same material as the source (23) and the drain (24) of the thin film transistor.

7. The array substrate according to claim 6, wherein
the source (23) and the drain (24) of the thin film transistor are disposed on a side of the gate (22) of the thin film transistor distal to the base (2), and the interlayer insulating layer (4) is disposed on a side of the gate insulating layer (3) distal to the base (2), or
the gate (22) of the thin film transistor is disposed on a side of the source (23) and the drain (24) of the thin film transistor distal to the base (2), and the gate insulating layer (3) is disposed on a side of the interlayer insulating layer (4) distal to the base (2).

8. The array substrate according to claim 1, wherein the second conductive structure (12) comprises metal.

9. The array substrate according to claim 1, wherein the conductive semiconductor structure (13) comprises a conductive low-temperature polysilicon layer, or
the first conductive structure (11) comprises metal.

10. A display device, comprising the array substrate according to any one of claims 1 to 9.

## Patentansprüche

1. Arraysubstrat, einen Anzeigebereich (31) und einen Fan-out-Bereich (32) umfassend, wobei das Arraysubstrat eine Basis (2) und mindestens eine Anschlussstruktur (1) aufweist, die auf der Basis (2) in dem Fan-out-Bereich (32) angeordnet ist, wobei die Anschlussstruktur (1) eine erste leitfähige Struktur (11) und eine leitfähige Halbleiterstruktur (13) aufweist, und eine orthogonale Projektion der leitfähigen Halbleiterstruktur (13) auf die Basis (2) eine orthogonale Projektion der ersten leitfähigen Struktur (11) auf die Basis (2) mindestens teilweise überlappt, und die erste leitfähige Struktur (11) dazu ausgelegt ist, Datensignale, Gate-Leitungssignale oder Taktsignale zu übertragen,
**dadurch gekennzeichnet, dass** die Anschlussstruktur (1) ferner eine zweite leitfähige Struktur (12) aufweist und eine orthogonale Projektion der zweiten leitfähigen Struktur (12) auf die Basis (2) die orthogonale Projektion der ersten leitfähigen Struktur (11) auf die Basis (2) mindestens teilweise überlappt,
wobei das Arraysubstrat einen Dünnschichttransistor aufweist, der auf der Basis (2) angeordnet ist;
wobei eine der ersten leitfähigen Struktur (11) oder der zweiten leitfähigen Struktur (12) in derselben Schicht wie ein Gate (22) des Dünnschichttransistors angeordnet ist und dasselbe Material wie das Gate (22) des Dünnschichttransistors aufweist und die andere der ersten leitfähigen Struktur (11) und der zweiten leitfähigen Struktur (12) in derselben Schicht wie eine Source (23) und ein Drain (24) des Dünnschichttransistors angeordnet ist und dasselbe Material wie die Source (23) und der Drain (24) des Dünnschichttransistors aufweist,
wobei eine erste Isolierschicht zwischen der ersten leitfähigen Struktur (11) und der leitfähigen Halbleiterstruktur (13) angeordnet ist, eine zweite Isolierschicht zwischen der ersten leitfähigen Struktur (11) und der zweiten leitfähigen Struktur (12) angeordnet ist und die erste Isolierschicht und die zweite Isolierschicht nacheinander auf der Basis (2) angeordnet sind; und
die leitfähige Halbleiterstruktur (13) auf einer der ersten Isolierschicht zugewandten Seite der Basis (2) angeordnet ist, die erste leitfähige Struktur (11) auf einer der ersten Isolierschicht von der Basis (2) abgewandten Seite angeordnet ist und die zweite leitfähige Struktur (12) auf einer der zweiten Isolierschicht von der Basis (2) abgewandten Seite angeordnet ist,
wobei das Arraysubstrat eine Vielzahl von Anschlussstrukturen (1) aufweist, die in einer Richtung parallel zur Erstreckungsrichtung des Arraysubstrats angeordnet sind, wobei jede der Anschlussstrukturen (1) eine erste leitfähige Struktur (11) aufweist, die Vielzahl der Anschlussstrukturen (1) sich eine einzige gemeinsame zweite leitfähige Struktur (12) teilt und die Vielzahl der Anschlussstrukturen (1) sich eine einzige gemeinsame leitfähige Halbleiterstruktur (13) teilt; und
Durchkontaktierungen (5) auf beiden Seiten der ersten leitfähigen Struktur (11) angeordnet sind und zwischen jeweils zwei benachbarten ersten leitfähigen Strukturen (11) nur eine Durchkontaktierung (5) angeordnet ist und die Durchkontaktierungen (5) die zweite Isolierschicht und die erste Isolierschicht so durchdringen, dass die leitfähige Halbleiterstruktur (13) über die Durchkontaktierungen (5) elektrisch mit der zweiten leitfähigen Struktur (12) verbunden ist.

2. Arraysubstrat nach Anspruch 1, wobei die erste leitfähige Struktur (11) in derselben Schicht wie ein Gate (22) des Dünnschichttransistors angeordnet ist und dasselbe Material wie das Gate (22) des Dünnschichttransistors aufweist.

3. Arraysubstrat nach Anspruch 2, wobei
eine Gate-Isolierschicht (3) zwischen dem Gate (22) des Dünnschichttransistors und der aktiven Schicht (21) des Dünnschichttransistors angeordnet ist; und
die leitfähige Halbleiterstruktur (13) auf einer der Gate-Isolierschicht (3) zugewandten Seite der Basis (2) angeordnet ist und die erste leitfähige Struktur (11) auf einer der Gate-Isolierschicht (3) von der Basis (2) abgewandten Seite angeordnet ist.

4. Arraysubstrat nach Anspruch 3, wobei
eine Zwischenschicht-Isolierschicht (4) zwischen einer Source (23) und einem Drain (24) des Dünnschichttransistors und der aktiven Schicht (21) des Dünnschichttransistors angeordnet ist und die Source (23) und der Drain (24) des Dünnschichttransistors auf einer von der Basis (2) abgewandten Seite der Zwischenschicht-Isolierschicht (4) angeordnet sind.

5. Arraysubstrat nach Anspruch 4, wobei
die Source (23) und der Drain (24) des Dünnschichttransistors auf einer von der Basis (2) abgewandten Seite des Gates (22) des Dünnschichttransistors angeordnet sind und die Zwischenschicht-Isolierschicht (4) auf einer von der Basis (2) abgewandten Seite der Gate-Isolierschicht (3) angeordnet ist oder
das Gate (22) des Dünnschichttransistors auf einer von der Basis (2) abgewandten Seite der Source (23) und des Drains (24) des Dünnschichttransistors angeordnet ist und die Gate-Isolierschicht (3) auf einer von der Basis (2) abgewandten Seite der Zwischenschicht-Isolierschicht (4) angeordnet ist.

6. Arraysubstrat nach Anspruch 1, wobei die erste leitfähige Struktur (11) in derselben Schicht wie eine Source (23) und ein Drain (24) des Dünnschichttransistors angeordnet ist und dasselbe Material wie die Source (23) und der Drain (24) des Dünnschichttransistors aufweist.

7. Arraysubstrat nach Anspruch 6, wobei
die Source (23) und der Drain (24) des Dünnschichttransistors auf einer von der Basis (2) abgewandten Seite des Gates (22) des Dünnschichttransistors angeordnet sind und die Zwischenschicht-Isolierschicht (4) auf einer von der Basis (2) abgewandten Seite der Gate-Isolierschicht (3) angeordnet ist oder
das Gate (22) des Dünnschichttransistors auf einer von der Basis (2) abgewandten Seite der Source (23) und des Drains (24) des Dünnschichttransistors angeordnet ist und die Gate-Isolierschicht (3) auf einer von der Basis (2) abgewandten Seite der Zwischenschicht-Isolierschicht (4) angeordnet ist.

8. Arraysubstrat nach Anspruch 1, wobei die zweite leitfähige Struktur (12) Metall aufweist.

9. Arraysubstrat nach Anspruch 1, wobei die leitfähige Halbleiterstruktur (13) eine leitfähige Niedertemperatur-Polysiliziumschicht aufweist oder
die erste leitfähige Struktur (11) Metall aufweist.

10. Anzeigevorrichtung, aufweisend das Arraysubstrat nach einem der Ansprüche 1 bis 9.

## Revendications

1. Substrat de matrice, comprenant une zone d'affichage (31) et une zone de sortance (32), dans lequel le substrat de matrice comprend une base (2) et au moins une structure de conducteur (1) disposée sur la base (2) dans la zone de sortance (32), dans lequel la structure de conducteur (1) comprend une première structure conductrice (11) et une structure à semi-conducteur conductrice (13), et une projection orthogonale de la structure à semi-conducteur conductrice (13) sur la base (2) se superpose au moins partiellement à une projection orthogonale de la première structure conductrice (11) sur la base (2), et la première structure conductrice (11) est configurée pour transmettre des signaux de données, des signaux de ligne de grille ou des signaux d'horloge,
**caractérisé en ce que** la structure de conducteur (1) comprend en outre une deuxième structure conductrice (12), et une projection orthogonale de la deuxième structure conductrice (12) sur la base (2) se superpose au moins partiellement à la projection orthogonale de la première structure conductrice (11) sur la base (2),
dans lequel le substrat de matrice comprend un transistor à couches minces disposé sur la base (2) ;
dans lequel une parmi la première structure conductrice (11) et la deuxième structure conductrice (12) est disposée dans une même couche qu'une grille (22) du transistor à couches minces et comprend un même matériau que la grille (22) du transistor à couches minces et l'autre parmi la première structure conductrice (11) et la deuxième structure conductrice (12) est disposée dans une même couche qu'une source (23) et un drain (24) du transistor à couches minces et comprend un même matériau que la source (23) et le drain (24) du transistor à couches minces,
dans lequel une première couche isolante est disposée entre la première structure conductrice (11) et la structure à semi-conducteur conductrice (13), une deuxième couche isolante est disposée entre la première structure conductrice (11) et la deuxième structure conductrice (12) et la première couche isolante et la deuxième couche isolante sont disposées successivement sur la base (2) ; et
la structure à semi-conducteur conductrice (13) est disposée sur un côté de la base (2) proximal de la première couche isolante, la première structure conductrice (11) est disposée sur un côté de la première couche isolante distal de la base (2) et la deuxième structure conductrice (12) est disposée sur un côté de la deuxième couche isolante distal de la base (2),
dans lequel le substrat de matrice comprend une pluralité de structures de conducteur (1) disposées dans une direction parallèle à une direction d'extension du substrat de matrice, chacune des structures de conducteur (1) comprend une première structure conductrice (11), la pluralité de structures de conducteur (1) partagent une unique deuxième structure conductrice (12) commune et la pluralité de structures de conducteur (1) partagent une unique structure à semi-conducteur conductrice (13) commune ; et
des trous d'interconnexion (5) sont disposés de part et d'autre de la première structure conductrice (11) et un seul trou d'interconnexion (5) est disposé entre toutes deux premières structures conductrices (11) adjacentes et les trous d'interconnexion (5) traversent la deuxième couche isolante et la première couche isolante de telle sorte que la structure à semi-conducteur conductrice (13) soit connectée électriquement à la deuxième structure conductrice (12) par l'intermédiaire des trous d'interconnexion (5).

2. Substrat de matrice selon la revendication 1, dans lequel la première structure conductrice (11) est disposée dans une même couche qu'une grille (22) du transistor à couches minces et comprend un même matériau que la grille (22) du transistor à couches minces.

3. Substrat de matrice selon la revendication 2, dans lequel
une couche isolante de grille (3) est disposée entre la grille (22) du transistor à couches minces et la couche active (21) du transistor à couches minces ; et
la structure à semi-conducteur conductrice (13) est disposée sur un côté de la base (2) proximal de la couche isolante de grille (3) et la première structure conductrice (11) est disposée sur un côté de la couche isolante de grille (3) distal de la base (2).

4. Substrat de matrice selon la revendication 3, dans lequel
une couche isolante intercouche (4) est disposée entre une source (23) et un drain (24) du transistor à couches minces et la couche active (21) du transistor à couches minces, et la source (23) et le drain (24) du transistor à couches minces sont disposés sur un côté de la couche isolante intercouche (4) distal de la base (2).

5. Substrat de matrice selon la revendication 4, dans lequel
la source (23) et le drain (24) du transistor à couches minces sont disposés sur un côté de la grille (22) du transistor à couches minces distal de la base (2) et la couche isolante intercouche (4) est disposée sur un côté de la couche isolante de grille (3) distal de la base (2), ou la grille (22) du transistor à couches minces est disposée sur un côté de la source (23) et du drain (24) du transistor à couches minces distal de la base (2) et la couche isolante de grille (3) est disposée sur un côté de la couche isolante intercouche (4) distal de la base (2).

6. Substrat de matrice selon la revendication 1, dans lequel la première structure conductrice (11) est disposée dans une même couche qu'une source (23) et un drain (24) du transistor à couches minces et comprend un même matériau que la source (23) et le drain (24) du transistor à couches minces.

7. Substrat de matrice selon la revendication 6, dans lequel
la source (23) et le drain (24) du transistor à couches minces sont disposés sur un côté de la grille (22) du transistor à couches minces distal de la base (2) et la couche isolante intercouche (4) est disposée sur un côté de la couche isolante de grille (3) distal de la base (2) ou
la grille (22) du transistor à couches minces est disposée sur un côté de la source (23) et du drain (24) du transistor à couches minces distal de la base (2) et la couche isolante de grille (3) est disposée sur un côté de la couche isolante intercouche (4) distal de la base.

8. Substrat de matrice selon la revendication 1, dans lequel la deuxième structure conductrice (12) comprend du métal.

9. Substrat de matrice selon la revendication 1, dans lequel la structure à semiconducteur conductrice (13) comprend une couche de polysilicium conductrice à basse température ou
la première couche conductrice (11) comprend du métal.

10. Dispositif d'affichage, comprenant le substrat de matrice selon une quelconque des revendications 1 à 9.
